Europäisches Patentamt

European Patent Office

Office européen des brevets

(19)

(11) **EP 0 772 299 B1**

(12) **EUROPEAN PATENT SPECIFICATION**

(45) Date of publication and mention
of the grant of the patent:
**14.05.2003 Bulletin 2003/20**

(51) Int Cl.⁷: **H03K 17/06**

(21) Application number: **95830455.2**

(22) Date of filing: **30.10.1995**

(54) **An interface circuit for controlling electronic switches with boosted voltage signals**

Interface-Schaltung zum Steuern von elektronischen Schaltern mit Signalen erhöhter Spannung

Circuit d'interface pour commander des commutateurs électroniques avec des signaux de tension surélevés

(84) Designated Contracting States:
**DE FR GB IT**

(43) Date of publication of application:
**07.05.1997 Bulletin 1997/19**

(73) Proprietor: **STMicroelectronics S.r.l.**
**20041 Agrate Brianza (Milano) (IT)**

(72) Inventors:
 • **Tomasini, Luciano**
  **I-20052 Monza-Milano (IT)**
 • **Castello, Rinaldo**
  **I-20043 Arcore-Milano (IT)**
 • **Clerici, Giancarlo**
  **I-20090 Vimodrone-Milano (IT)**
 • **Bietti, Ivan**
  **I-46040 Casal Romano-Mantova (IT)**

(74) Representative: **Maggioni, Claudio et al**
 **Jacobacci & Partners S.p.A.,**
 **Via Senato, 8**
 **20121 Milano (IT)**

(56) References cited:
 **FR-A- 2 162 159**      **US-A- 5 291 446**

 • **ELECTRONIC ENGINEERING, vol. 61, no. 745, January 1989 LONDON GB, pages 43-48, XP 000120696 TAYLOR ET AL. 'The IR8200 monolithic DMOS H-bridge power control IC'**

EP 0 772 299 B1

## Description

The present invention relates to an interface circuit disposed between a generator of control signals and a plurality of electronic switches in order to produce boosted voltage signals corresponding to the control signals for the activation of the electronic switches, as disclosed in "Electronic Engineering, vol. 61, no. 745, January 1989, London GB; pages 43-48" and defined in the preamble of claim 1.

In digital integrated circuits, the need to have boosted voltage signals arises from the fact that the so-called "body" effect of MOS transistors requires gate voltages greater than the supply voltage of the circuit. Internal supplies which use voltage multipliers with capacitors are generally provided to produce these voltages. To achieve relatively high currents from the multipliers, the capacitors have to have correspondingly high capacitances. This constitutes a limitation for the production of supplies with fully-integrated voltage multipliers since, as is known, the capacitance of an integrated capacitor is directly proportional to the area of semiconductor occupied thereby, naturally as well as to the thickness of the dielectric which is, however, generally fixed by the manufacturing process. Clearly, the need to produce voltage multipliers which can supply large currents conflicts with the need to reduce the dimensions of integrated circuits and hence their cost..

The object of the present invention is to provide an interface circuit of the type defined above which does not require a voltage multiplier with a large capacitance for its operation.

This object is achieved, according to the invention, by the provision of an interface circuit defined and characterized in general in the first claim.

The invention will be understood better from the following detailed description of an embodiment thereof and of some variants, given with reference to the appended drawings, in which:

Figure 1 is a block diagram of a circuit unit which comprises an interface for producing boosted voltage signals,

Figure 2 is a conceptual block diagram of a circuit unit which includes an interface according to the invention,

Figure 3 is a circuit diagram of an interface according to the invention, and

Figures 4 and 5 show two variants of the circuit diagram of Figure 3.

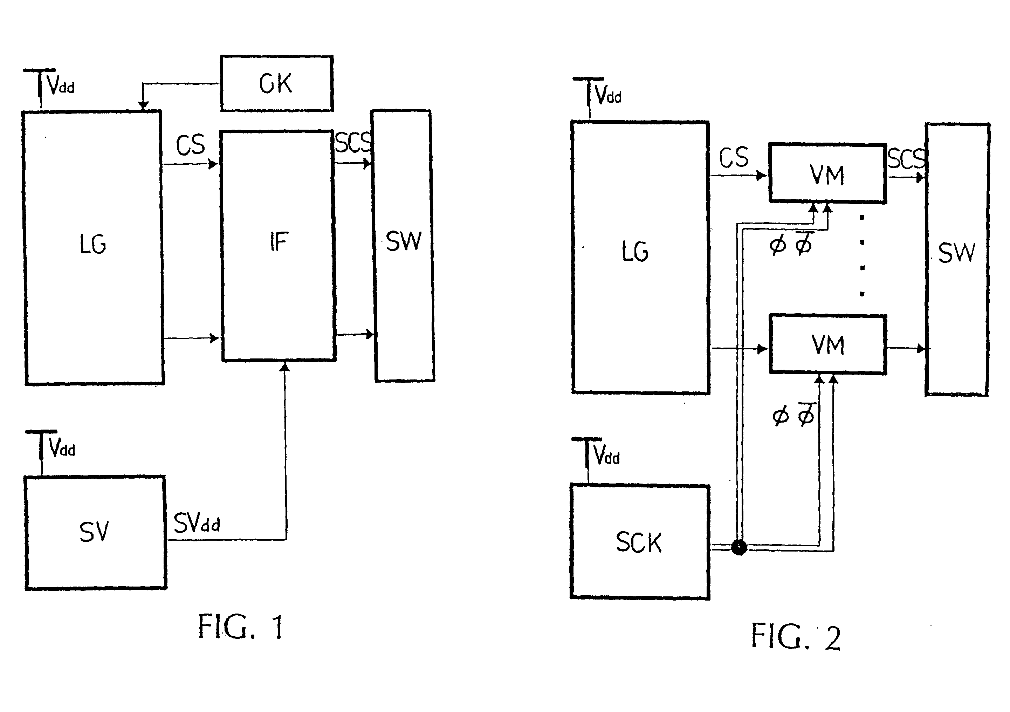

Figure 1 shows a typical circuit unit for producing boosted-voltage logic control signals in an integrated circuit. A booster SV supplied by the voltage supply Vdd of the integrated circuit generates a direct-current voltage SVdd greater than the supply voltage Vdd. A logic unit LG timed by a clock circuit CK which is also supplied by the voltage Vdd produces control signals CS for selectively activating electronic switches SW. An interface circuit IF connected between the logic unit LG and the set of electronic switches SW produces boosted-voltage signals SCS corresponding to the control signals CS of the logic unit LG using the voltage SVdd of the booster SV as a supply voltage.

A circuit structure of this type is used, for example, for regulating the gain of a variable-gain amplifier when the regulation has to be carried out in dependence on various operating parameters of the integrated circuit of which the amplifier forms part.

In this case, the logic unit LG represents the circuits which receive and process these operating parameters and the set of electronic switches SW is constituted by a set of controllable conduction means, typically MOS transistors, the closed or open state of which affects the gain of the amplifier.

In practice, the boosted voltage signals output by the interface circuit IF are applied to the gate electrodes of the transistors which are to be made conductive or cut off. The interface IF is constituted by logic gates typically formed by MOS transistors connected by their source and drain terminals between the boosted-voltage supply terminals SVdd of the booster SV. Each time one of these gates switches from one logic state to the other, in order to give rise to a boosted-voltage control signal SCS, a considerable current is absorbed by the booster SV. Naturally the latter has to be designed so as to be able to supply the maximum current which may be required at any moment and is therefore oversized for most of its actual use. On the other hand, if its size were based on the average current absorption, when a transitory current absorption greater than that tolerable by the booster SV took place, the boosted voltage SVdd would be reduced so that undesired coupling could occur between boosted-voltage control signals.

According to the invention shown in the conceptual diagram of Figure 2, in which reference symbols identical to those of Figure 1 indicate the same components or signals, the interface circuit between the logic unit LG which generates the control signals CS and the set of switches SW is constituted by a plurality of voltage multipliers VM connected between the outputs of the logic unit LG and the terminals for activating the electronic switches SW. Each voltage multiplier VM may be associated with one or more terminals for activating the electronic switches SW. A generator of boosted-voltage clock signals SCK is also provided and controls the individual multipliers VM.

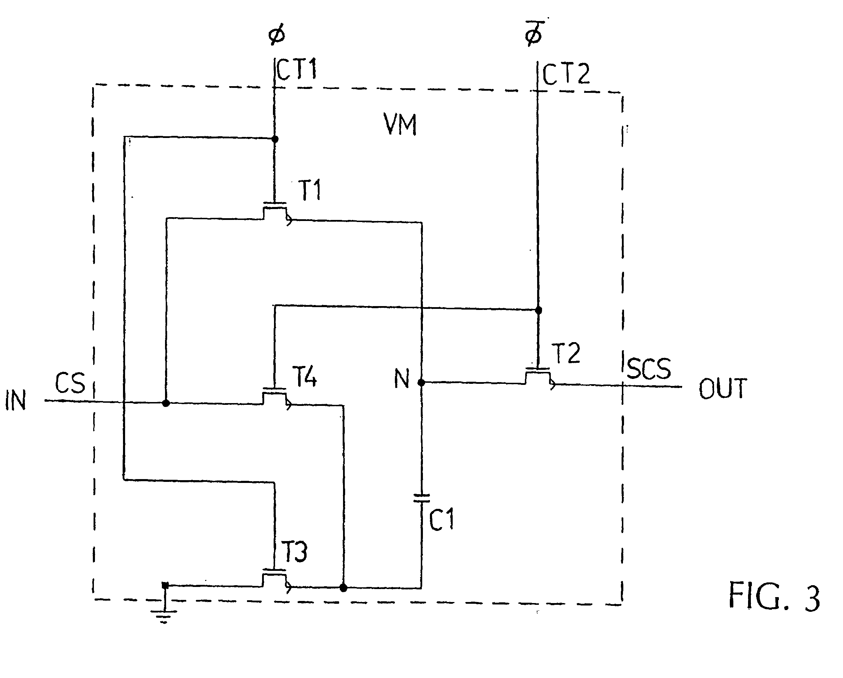

The circuit structure of a voltage multiplier VM, known per se, as disclosed in FR-A-2 162 159, is shown in Figure 3. The input IN and the output OUT of the multiplier are connected to one another by the source-drain paths, arranged in series, of two N-channel MOS transistors, indicated T1 and T2. A capacitor C1 is connected between the junction N of the source of T1 and of the drain of T2 and the source of a third MOS transistor T3 the drain of which is connected to the ground terminal which is the reference terminal common to the input and the output of the multiplier. A fourth MOS transistor T4 has its source connected to the source of the transistor T3 and its drain connected to the input IN. The gate electrodes of the transistors T1 and T3 are connected to a first control terminal CT1 of the multiplier and the gate electrodes of the transistors T2 and T4 are connected to a second control terminal CT2 of the multiplier. The control terminals CT1 and CT2 are connected to the boosted-voltage clock generator SCK in order to receive therefrom first and second activation signals indicated $\phi$ and $\bar{\phi}$. There is no phase overlapping of these activation signals, that is, they are never both at a high level or both at a low level simultaneously. The operation of the multiplier of Figure 3 will now be considered. When the signal $\phi$ is at a high level and $\bar{\phi}$ is at a low level, the transistors T1 and T3 are conductive and the transistors T2 and T4 are cut off, the capacitor C1 is charged to the input voltage IN, that is, the voltage of the signal CS. Upon the next change of the clock signal to the low level, $\phi$ is at a low level and $\bar{\phi}$ is at a high level so that the situation is reversed, that is, T1 and T3 are cut off and T2 and T4 are conductive. The capacitor C1 is in series between the input IN and the output OUT so that the voltage at the output OUT, that is, the signal SCS, is the sum of the voltage at the input IN and that at the terminals of the capacitor C1, that is, twice the voltage of the input signal CS.

As can be seen, the boosted voltage signals for controlling the electronic switches SW are produced by the multiplication of the voltages of the control signals CS output by the logic unit LG by two, with charging solely of transistor gate electrodes, that is, with the use of much lower currents than those required by known circuits in which the boosted voltage had to supply the source-drain paths of transistors. In summary, with the circuit according to the invention, it is possible to use capacitors of lower capacitance and hence of smaller area, to the benefit of the final size of the integrated circuit.

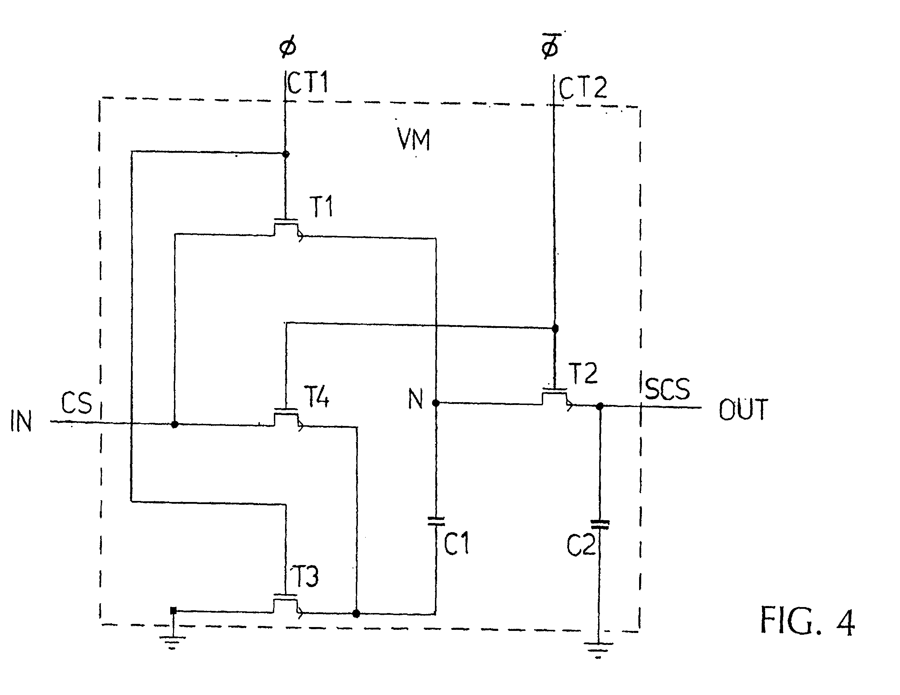

Figure 4 shows a variant of the circuit of Figure 3 which can be used if there is a residual ripple at the output OUT, due to the clock signal. Since this could cause the injection of charges into the electronic switch which is to be activated, according to this variant, an additional capacitor C2 is provided and acts as a smoothing filter between the output terminal OUT and the ground.

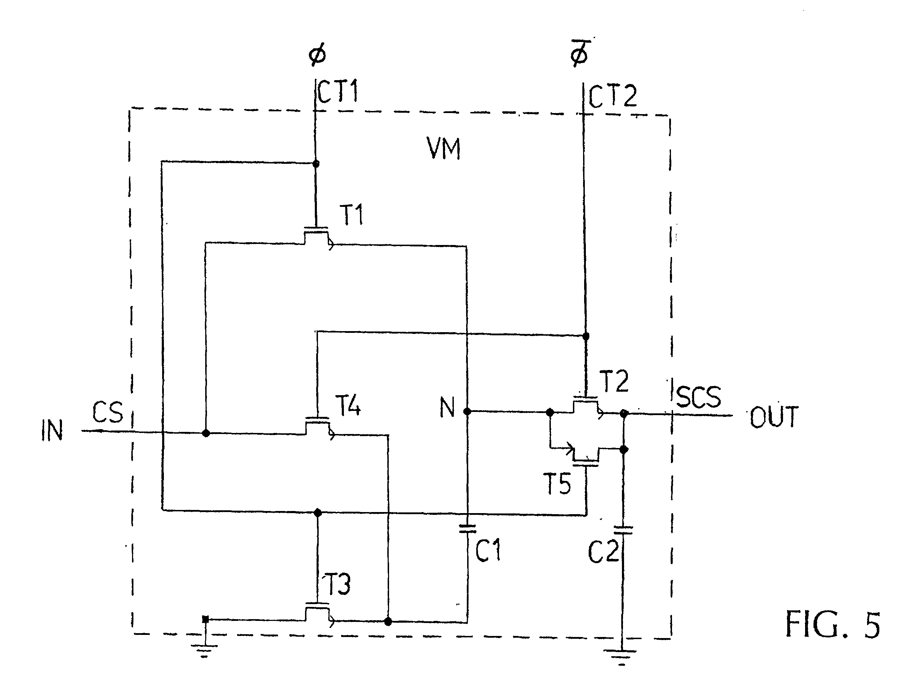

A further variant shown in Figure 5 serves to ensure conduction between the junction N and the output OUT during the clock signal $\bar{\phi}$ when the conduction threshold of the transistor T2 is raised because of the body effect which occurs in the transistor T2 when the voltage between source and drain is twice the voltage of the input signal CS. It consists of the addition of a P-channel MOS transistor, indicated T5, with its source and drain terminals connected to the drain and source terminals of the transistor T2, respectively, and with its gate terminal connected to the first control terminal CT1, so that it is made conductive or cut off during the same phase of the clock signal as the transistor T2.

**Claims**

1. An interface circuit disposed between a generator (LG) of control signals (CS) and a plurality of electronic switches (SW) in order to produce boosted voltage signals (SCS) corresponding to the control signals (CS) for the activation of the electronic switches (SW), comprising a clock signal generator (SCK) and a plurality of voltage multipliers (VM) each of which has an input connected to an output of the control signal generator (LG) to receive one of said control signals (CS), an output connected to an activation terminal of at least one of said plurality of electronic switches (SW), two control terminals connected to the clock signal generator and at least one capacitive means, **characterized in that** the clock signal generator comprises a generator (SCK) of boosted voltage clock signals and the at least one capacitive means (C1) is so connected as to be charged to the voltage of the control signal (CS).

2. A circuit according to Claim 1, in which each voltage multiplier (VM) comprises first and second controllable conduction means (T1 and T2) connected in series with one another between the input (IN) and the output (OUT) of the multiplier, said at least one capacitive means (C1) is connected by a first terminal to the junction (N) between the first and second controllable conduction means (T1 and T2) and by its second terminal both to a reference terminal (ground) common to the input and to the output via a third controllable conduction means (T3), and to the input (IN) of the multiplier via a fourth controllable conduction means (T4), the activation terminals of the first and third controllable conduction means (T1 and T3) are connected to a first control terminal (CT1) of the multiplier in order to receive a first activation signal ($\phi$) from the clock generator (SCK) and the terminals of the second and fourth controllable conduction means are connected to a second control terminal (CT2) of the multiplier in order to receive a second activation signal ($\bar{\phi}$) from the clock generator (SCK), there being no phase overlapping of the first and second activation signals.

3. A circuit according to Claim 2, in which an additional capacitive means (C2) is provided between the output (OUT) of the multiplier and the reference terminal (ground).

4. A circuit according to Claim 2 or Claim 3, in which the second controllable conduction means (T2) is an N-channel MOS transistor and in which a P-channel MOS transistor (T5) is provided, with its source and its drain connected, respectively, to the drain and to the source of the N-channel MOS transistor and its gate electrode connected to the first control terminal (CT1).

**Patentansprüche**

1. Eine Schnittstellenschaltung, die zwischen einem Generator (LG) von Steuersignalen (CS) und einer Mehrzahl von elektronischen Schaltern (SW) angeordnet ist, um verstärkte Spannungssignale (SCS) zu erzeugen, die den Steuersignalen (CS) für die Aktivierung der elektronischen Schalter (SW) entsprechen, die einen Taktsignalgenerator (SCK) und eine Mehrzahl von Spannungsmultiplizierern (VM) aufweisen, von denen jeder einen Eingang, der mit einem Ausgang des Steuersignalgenerators (LG) verbunden ist, um eines der Steuersignale (CS) zu empfangen, einen Ausgang, der mit einem Aktivierungsanschluß von zumindest einem der Mehrzahl von elektronischen Schaltern (SW) verbunden ist, zwei Steueranschlüsse, die mit dem Taktsignalgenerator verbunden sind, und zumindest eine kapazitive Einrichtung aufweist, **dadurch gekennzeichnet, daß** der Taktsignalgenerator einen Generator (SCK) verstärkter Spannungstaktsignale aufweist und die zumindest eine kapazitive Einrichtung (C1) angeschlossen ist, um auf die Spannung der Steuersignale (CS) geladen zu werden.

2. Eine Schaltung gemäß Anspruch 1, bei der jeder Spannungsmultiplizierer (VM) eine erste und eine zweite steuerbare Leitungseinrichtung (T1 und T2) aufweist, die in Reihe zueinander zwischen den Eingang (IN) und den Ausgang (OUT) des Multiplizierers geschaltet sind, wobei die zumindest eine kapazitive Einrichtung (C1) durch einen ersten Anschluß mit dem Übergang (N) zwischen der ersten und der zweiten steuerbaren Leitungseinrichtung (T1 und T2), und durch ihren zweiten Anschluß sowohl mit einem Referenzanschluß (Masse), der dem Eingang und dem Ausgang gemeinsam ist, über eine dritte steuerbare Leitungseinrichtung (T3), als auch mit dem Eingang (IN) des Multiplizierers über eine vierte steuerbare Leitungseinrichtung (T4) verbunden ist, wobei die Aktivierungsanschlüsse der ersten und der dritten steuerbaren Leitungseinrichtung (T1 und T3) mit einem ersten Steueranschluß (CT1) des Multiplizierers verbunden sind, um ein erstes Aktivierungssignal (Φ) von dem Taktgenerator (SCK) zu empfangen, und wobei die Anschlüsse der zweiten und der vierten steuerbaren Leitungseinrichtung mit einem zweiten Steueranschluß (CT2) des Multiplizierers verbunden sind, um ein zweites Aktivierungssignal ($\overline{\Phi}$) von dem Taktgenerator (SCK) zu empfangen, wobei keine Phase vorliegt, in der das erste und das zweite Aktivierungssignal überlappen.

3. Eine Schaltung gemäß Anspruch 2, bei der eine zusätzliche kapazitive Einrichtung (C2) zwischen dem Ausgang (OUT) des Multiplizierers und dem Referenzanschluß (Masse) vorgesehen ist.

4. Eine Schaltung gemäß Anspruch 2 oder Anspruch 3, bei der die zweite steuerbare Leitungseinrichtung (T2) ein N-Kanal-MOS-Transistor ist und bei der ein P-Kanal-MOS-Transistor (T5) vorgesehen ist, dessen Source bzw. Drain mit dem Drain und der Source des N-Kanal-MOS-Transistors verbunden sind, und dessen Gateelektrode mit dem ersten Steueranschluß (CT1) verbunden ist.

**Revendications**

1. Circuit d'interface disposé entre un générateur (LG) de signaux de commande (CS) et une pluralité de commutateurs électroniques (SW) pour produire des signaux de tension augmentée (SCS) correspondant aux signaux de commande (CS) pour l'activation des commutateurs électroniques (SW), comprenant un générateur de signal d'horloge (SCK) et une pluralité de multiplieurs de tension (VM) dont chacun a une entrée connectée à une sortie du générateur de signal de commande (LG) afin de recevoir l'un desdits signaux de commande (CS), une sortie connectée à une borne d'activation d'au moins l'un de la pluralité de commutateurs électroniques (SW), deux bornes connectées au générateur de signal d'horloge et au moins un moyen capacitif, **caractérisé en ce que** le générateur de signal d'horloge comprend un générateur (SCK) de signaux d'horloge de tension augmentée et cet au moins un moyen capacitif (C1) est connecté de façon à être chargé à la tension du signal de commande (CS).

2. Circuit selon la revendication 1, dans lequel chaque multiplieur de tension (VM) comprend des premier et second moyens à conduction réglable (T1 et T2) connectés en série l'un à l'autre entre l'entrée (IN) et la sortie (OUT) du multiplieur ; ledit au moins un moyen capacitif (C1) est connecté par une première borne à la jonction (N) entre les premier et second moyens à conduction réglable (T1 et T2) et par sa seconde borne à la fois à une borne de référence (masse) commune à l'entrée et à la sortie par l'intermédiaire d'un troisième moyen à conduction réglable (T3), et à l'entrée (IN) du multiplieur par l'intermédiaire d'un quatrième moyen à conduction réglable (T4), les bornes d'activation des premier et troisième moyens à conduction réglable (T1 et T3) sont connectées à une première borne de commande (CT1) du multiplieur pour recevoir un premier signal d'activation ($\phi$) du générateur d'horloge (SCK) et les bornes des second et quatrième moyens à conduction réglable sont connectées à une seconde borne de commande (CT2) du multiplieur afin de recevoir un second signal d'activation ($\bar{\phi}$) du générateur d'horloge (SCK), aucun chevauchement de phase ne se produisant entre les premier et second signaux d'activation.

3. Circuit selon la revendication 2, dans lequel un moyen capacitif supplémentaire (C2) est prévu entre la sortie (OUT) du multiplieur et la borne de référence (masse).

4. Circuit selon la revendication 2 ou 3, dans lequel le second moyen à conduction réglable (T2) est un transistor MOS à canal N, et dans lequel il est prévu un transistor MOS à canal P (T5), sa source et son drain étant respectivement connectés au drain et à la source du transistor MOS à canal N et son électrode de grille étant connectée à la première borne de commande (CT1).

FIG. 2

FIG. 1

FIG. 3

FIG. 4

FIG. 5

EP 0 772 299 B1